# EUROPEAN PATENT SPECIFICATION

(11) **EP 0 887 935 B1**
(45) Date of publication and mention of the grant of the patent: **01.06.2005**
(21) Application number: 97630089.7
(22) Date of filing: 19.12.1997
(51) Int. Cl.: H03K 19/003

(54) **Noise isolation circuit**
Störisolierungsschaltung
Circuit d'isolation aux bruits

(30) Priority: 27.06.1997 US 883937
(43) Date of publication of application: 30.12.1998
(73) Proprietor: UNITED MEMORIES, INC., Colorado Springs, CO 80919 (US); Nippon Steel Semiconductor Corp., Tateyama-shi, Chiba 294 (JP)
(72) Inventor: Fish, David, Tateyami-shi, Chiba 294 (JP)
(74) Representative: Schmitz, Jean-Marie

(56) References cited:
- EP-A- 0 237 898
- EP-A- 0 311 102
- PATENT ABSTRACTS OF JAPAN vol. 010, no. 325 (E-451), 6 November 1986 & JP 61 133724 A (NEC CORP), 21 June 1986
- PATENT ABSTRACTS OF JAPAN vol. 016, no. 396 (P-1407), 21 August 1992 & JP 04 130514 A (MITSUBISHI ELECTRIC CORP), 1 May 1992
- PATENT ABSTRACTS OF JAPAN vol. 017, no. 328 (E-1385), 22 June 1993 & JP 05 037342 A (NEC KYUSHU LTD), 12 February 1993

## Description

### BACKGROUND OF THE INVENTION

### 1. Field of the Invention.

The present invention relates, in general, to input/output (I/O) circuits, and, more particularly, to an I/O circuit that is isolated from noise occurring at a predictable time after a state change.

### 2. Relevant Background.

Digital circuits receive and process logic signals These logic signals comprise two or more "states" or logic levels where each state is typically represented by a unique voltage. Most digital circuits are binary having two states (i.e., logic HIGH and logic LOW) represented by two voltages. To conserve power, increase circuit density on chips and increase switching speed of the logic circuits, there is a trend to reduce the span between the two voltages. Commonly available circuits use 3.3 V and 0.0 V power supply busses allowing a span between logic levels of around 3 V

A fundamental capability of any logic circuit is its ability to distinguish or discriminate between the voltage representing each of the logic states. In the case of binary logic, the logic signals can theoretically be distinguished by comparison to a reference the span between logic level voltages decreases, however, this comparison becomes more problematic. Also, when more than two logic levels are used, the difference between adjacent logic level voltages is difficult to distinguish. In these circuits, the logic level discriminator becomes increasingly sensitive to noise, particularly noise that affects the voltage on the power supply busses.

For example, in a dynamic random access memory (DRAM) circuit, an entire row of memory cells is addressed at one time using a row address line. Each row address line extends across a memory chip to hundreds of memory circuits. The row address line has significant capacitance and the memory circuits themselves are a significant capacitive load. Hence, the row address operation causes significant current flow in the power supply bus wiring and corresponding current resistance (IR) voltage loss in the bus wiring. The voltage loss results in incorrect discrimination between logic levels for a brief period of time after the row address signal occurs unless steps are taken to ensure that the power supply busses are not loaded by the signal transition.

Previous circuits attempt to solve the bus loading problem by independently routing power (V_{DD}) and ground (V_{SS}) bussing about the integrated circuit. In this manner, circuits that are used to discriminate logic levels are coupled to voltage supply busses that are separate from the loaded supply busses. However, independent routing consumes more chip area resulting in larger, more costly chips. Also, independent routing can reduce overall power and ground effectiveness.

Another solution is to use Schmitt triggers in the discriminator circuits. A Schmitt trigger is essentially a comparator with hysteresis. Schmitt triggers, however, merely reduce noise sensitivity, not eliminate it. Because they introduce hysteresis they reduce the input level margin making them less effective as the voltage span between logic levels decreases.

Another solution is to use "de-glitch" or "de-bounce" circuits. These circuits essentially add a delay in series with the input before a valid output signal is made available. For example, in a memory circuit a de-glitch circuit would not make a data output valid until after a delay sufficient for the power supply busses to stabilize. While these circuits ensure valid data output, they by definition add delay and slow response of the system. Hence, a need remains for a input/output circuit that is insensitive to noise yet does not add excessive delay or decrease the input level margin.

In EP-A-0 237 989 there is described a receiver for an integrated circuit according to the preamble of claim 1. More specifcally, EP-A-0 237 898 discloses an LSI chip circuit comprising an input buffer receiving an external input signal and generating a buffered input signal in response thereto, wherein the buffer is selectively enabled by a control signal, a latch receiving the buffered input signal and generating a latched output signal, a delay circuit coupled to receive the latched output signal, and a comparator receiving both the latched output signal and the delayed signal and having an output coupled to the input buffer to generate the control signal.

A method for receiving a signal in an integrated circuit according to the preamble of claim 6 is also known from EP-A-0 237 898.

The primary objective of the present invention is to overcome the aforementioned problem of providing a circuit that is insentitive to noise occurring at a predictable time after a change state without decreasing the input level margin.

To achieve this, the receiver of the invention is charaterized by the features claimed in the characterizing part of claim 1 and the invention provides a method according to the characterizing part of claim 6.

Basically, according to the invention, the input buffer comprises a CMOS inverter, a first switch coupled between the CMOS inverter and a V_{DD} voltage supply, the first switch having a control electrode for receiving the control signal, and a second switch coupled between the CMOS inverter and a V_{SS} voltage supply, the second switch having a control electrode for receiving the control signal.

A delay circuit is coupled to receive the latched output signal and to generate a delayed signal. A comparator is coupled to receive both the latched output signal and the delayed signal. The comparator has an output coupled to the input buffer to generate the control signal.

The present invention also involves a method for receiving a signal in an integrated circuit. The received signal is amplified by an amplifier and coupled to a latch. The amplifier is decoupled from the latch in response to a change in state of the latched signal. After a preselected duration of time, the amplifier is re-coupled to the latch.

### BRIEF DESCRIPTION OF THE DRAWINGS.

FIG. 1 illustrates in block diagram form a noise isolation circuit in accordance with the present invention;
FIG. 2 illustrates a logic circuit diagram implementing the embodiment shown in FIG. 1;
FIG. 3 illustrates a schematic diagram implementing the logic circuit of FIG. 2;
FIG. 4 illustrates a timing diagram of a prior art logic circuit;
FIG. 5 illustrates a timing diagram of a circuit in accordance with the present invention; and
FIG. 6 illustrates a timing diagram of exemplary control signals generated by a circuit in accordance with the present invention.

### DETAILED DESCRIPTION OF THE PREFERRED EMBODIMENTS

The present invention involves a noise isolation circuit that functions to latch valid data when it is first available and to prevent the latched output from changing during time periods where noise is expected. Such expected noise occurs in circuits when the power supplies are loaded at predictable times. However, the present invention is applicable to any circuit or situation in which the predictable noise event occurs for a known duration after the signal changes state.

The present invention is used in the receiver portion of an input/output (I/O) device. When used as an input, the circuit in accordance with the present invention isolates selected circuitry from noise created from a previous stage. When used as an output, the circuit in accordance with the present invention isolates external circuitry from noise created internal to the chip. These applications are substantially equivalent.

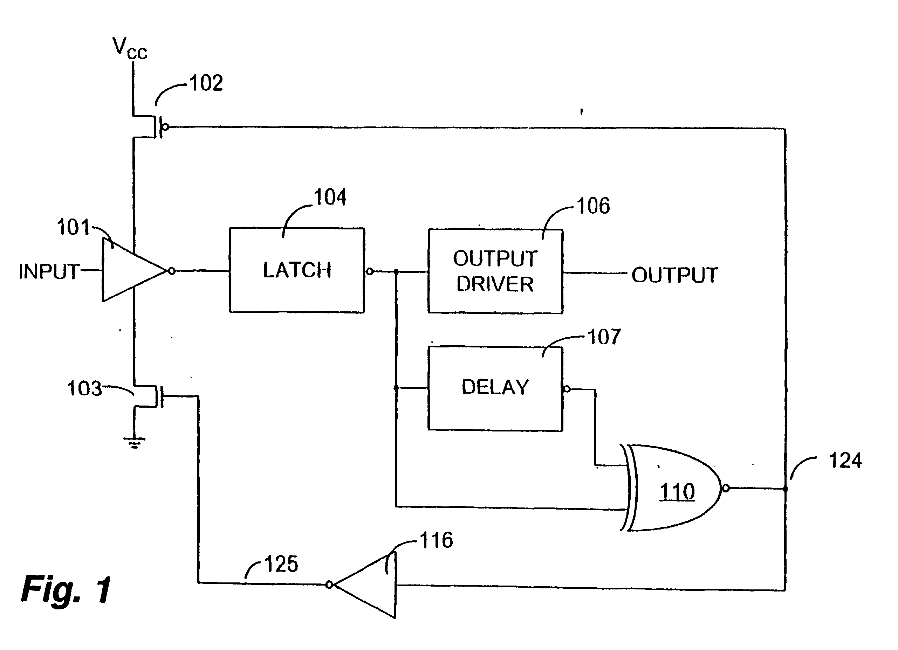

FIG. 1 illustrates an embodiment in accordance with the present invention in block diagram form. An input buffer 101 is coupled to receive an external input signal. Input buffer 101 has power nodes that are coupled to a first power supply VCC and a second power supply that is at ground potential in FIG 1. The second power supply is referred to as VSS and may be a negative voltage in some systems. In conventional circuits, buffer 101 is coupled directly to the power supplies so that it receives a constant source of power and remains constantly enabled and operative. In accordance with the present invention, however, a first switch 102 is coupled in series between a power node of buffer 101 and the first power supply VCC. A second switch 103 is coupled in series with a second power node of buffer 101 and the VSS power supply. VCC is typically a positive power supply while VSS is negative or ground. In typical applications, VDD is 5 volts or 3.3 volts while VSS is ground.

Input buffer 101 is shown as an inverting amplifier although other input buffer circuitry is known and may be equivalent to the particular embodiment shown. Throughout the description of the preferred embodiment, specific polarities are noted and inverting or non-inverting outputs and inputs to each of the devices are shown, although, it should be understood that inversion is a matter of design choice and may or may not be used so long as the output functionality is achieved.

The output of input buffer 101 is coupled to latch 104. Buffer 101 includes output drivers that have sufficiently low impedance to change the state of latch 104. Latch 104 is asynchronous as it does not require a clock signal and serves to latch whatever signal is applied by buffer 101 when buffer 101 is enabled. However, when switches 102 and 103 are turned off, buffer 101 is disabled and cannot drive or change the state of latch 104. In this case, latch 104 will remain in its existing state until input buffer 101 is re-enabled.

The output of latch 104 is coupled to an output driver 106 that includes amplifier circuitry sufficient to drive the output signal onto external circuitry (not shown). Output driver 106 also provides the correct polarity for the output signal such that the output matches the input polarity.

The output of latch 104 is also coupled to a control circuit formed by delay 107 and comparison circuit 110. Delay circuit 107 provides or generates a delayed version of the latched signal on its output. In the preferred embodiment, delay circuit 107 also inverts the latch signal such that in steady state the input to comparison circuit 110 is always the same. Comparison circuit 110 comprises combinatorial logic that, in the preferred embodiment, generates a logic high when both of the inputs to comparison circuit 110 are the same. Comparison circuit 110 generates a logic low when the binary states of the inputs differ from each other. Generally, comparison circuit 110 provices an exclusive-or type function with an inverted output. Comparison circuit 110 outputs a control signal on node 124 that is coupled to switch 102. The control signal on node 124 is also coupled through inverter 116 to switch 103 via node 125.

In operation, as the input to buffer 101 changes, the new signal is latched and held in latch 104. Delay circuit 107 ensures that the inputs to comparison circuit 110 have different logic states for some preselected time period (determined by delay 107) after the output of latch 104 changes. Comparison circuit 110 then generates a control signal 124 that deactivates switch 102 during the preselected time period. Similarly, the inverted control signal on line 125 turns off switch 103 during the preselected time period. Hence, during the preselected time input buffer 101 is deactivated or disabled and cannot change the output of latch 104 or output driver 106. The delay provided by delay circuit 107 is selected to be of sufficient duration to allow any power fluctuations on the VDD or VSS !power supply buses to stabilize.

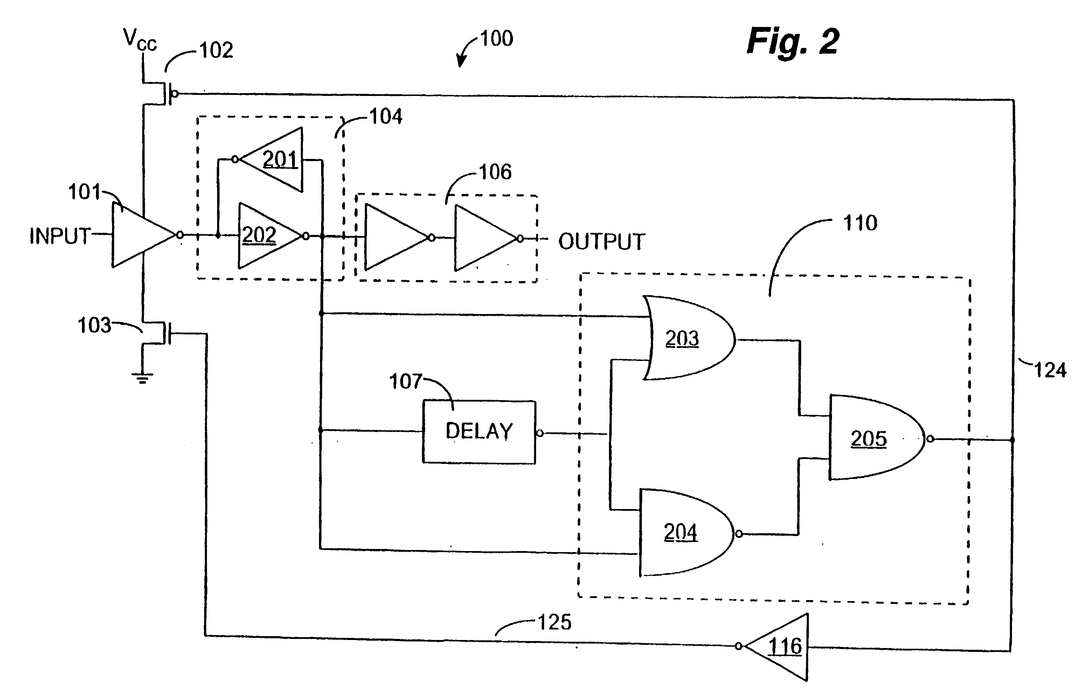

FIG. 2 shows the circuit of FIG. 1 at a gate-level logic diagram. Latch 104 is conveniently provided by a pair of inverters 201 and 202 coupled in a regenerative circuit. Advantageously, inverter 201 is a weak inverter as compared to inverter 202. This arrangement allows input buffer 101 to drive a signal onto the latch only when buffer 101 is enabled while making latch 104 insensitive to changes in the output of buffer 101 when buffer 101 is disabled. In a specific implementation, output buffer 106 comprises a pair of series coupled inverters sized to provide the required output impedance.

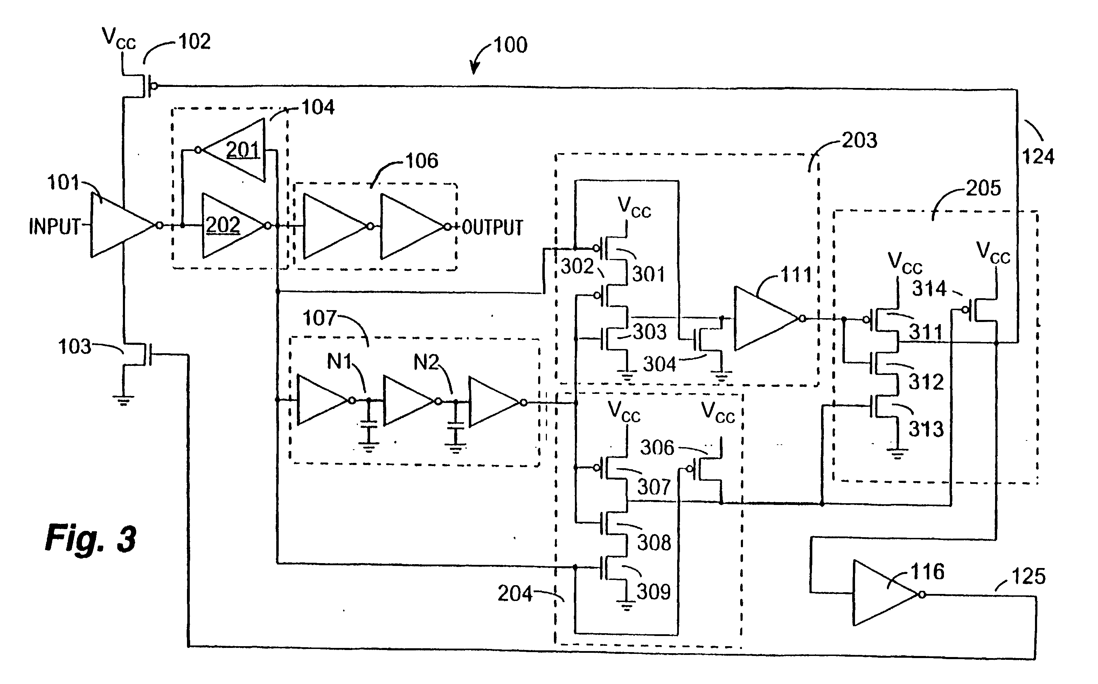

Comparison circuit 110 is conveniently formed by an OR gate 203 that receives the delayed signal from delay 107 and the latched signal from latch 104. A NAND gate 204 also receives the delayed signal from delay 107 and the latched signal from latch 104. The outputs of gates 203 and 204 are coupled as inputs to NAND gate 205. The output of gate 205 is coupled to node 124. The logic circuit implementing comparison circuit 110 shown in FIG. 2 is an example only and illustrates one practical circuit for implementing the combinatorial logic described above. However, equivalent circuits are known and may be more desirable depending on the particular logic technology used. As shown in FIG. 3, the present invention is intended to be implemented using CMOS technology. The gates chosen in FIG. 2 are chosen primarily to simplify the circuitry for implementation in CMOS technology.

As shown in FIG. 3, delay circuit 107 is implemented as a plurality of series coupled inverters. In the preferred embodiment an odd number of inverters are used so that the steady state output of delay 107 is inverted as compared to the steady state output of latch. This may be changed if desired with appropriate modifications to the remaining circuitry. Any number of delay stages may be used in delay circuit 107 to provide any desired delay so long as input buffer 101 is re-enabled in sufficient time to receive the next signal.

OR gate 203 is formed by a CMOS NOR gate comprising transistors 301, 302, 303 and 304. The gates of transistors 301 and 304 are coupled to the output of latch 104. The gates of transistors 302 and 303 are coupled to the output of delay circuit 107. The output of CMOS NOR gate is coupled from the drain of 304 to the input of CMOS inverter 111. The details of CMOS 111 are not shown and are well known in the industry.

NAND gate 204 is formed by transistors 307, 308, 309 and 306. The gates of transistors 307 and 308 are coupled to the output of delay circuit 107. The gates of transistors 306 and 309 are coupled to the output of latch 104. The output of NAND gate 204 is coupled to the input of NAND gate 205. NAND gate 205 comprises transistors 311, 312, 313 and 314. One input of NAND gate 205 is formed by the gates of transistors 311 and 312, while the second input of NAND gate 205 is formed by the gates of transistors 313 and 314. The output of NAND gate 205 is node 124 that is coupled back to switch 102 to provide a negative going control signal to switch 102.

Switch 102 is a p-channel transistor in the preferred embodiment and so is on while a logic low signal is applied to line 124. Switch 103 comprises an n-channel transistor that is on while a logic high signal is applied to node 125. Circuit 100 shown in FIG. 3 generates a logic low on node 124 and a logic high on node 125 during steady state (i.e., while both the input and delayed input have the same logic value), with opposite states for the preselected period of time after the input to buffer 101 changes state.

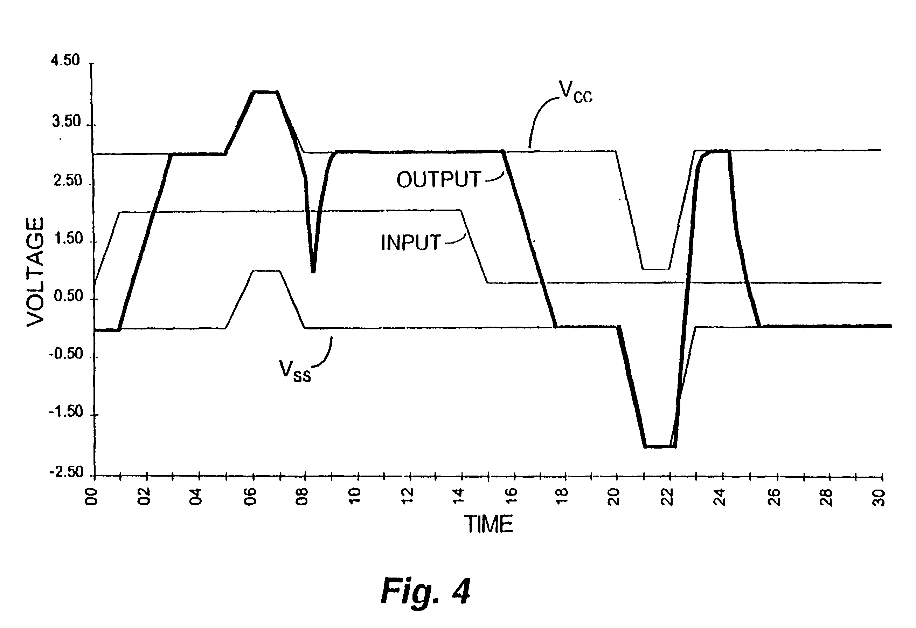

FIG. 4 - FIG. 6 illustrate wave diagrams showing advantages of the noise isolation circuit in accordance with the present invention. FIG. 4 is a prior art device without noise immunity. In each of FIG. 4 - FIG. 6 the horizontal axis represents time and the vertical axis represents voltage. At time 01 the input signal Vin has completed changing from a logic low to a logic high. After a short duration to time period 03, the output signal, shown in bold, approaches a logic high level also. At approximately time 05 a noise spike occurs on the power supply buses forcing the VSS power supply to approximately 1 volt and the VCC power supply to approximately 4 volts. It can be seen that during this time period the input signal Vin is much closer to VSS than VCC. This results in an incorrect determination of the logic level of Vin forcing the output to suddenly switch to a logic low at time 08. Once the power supply spike has stabilized, Vout again returns to the correct logic value.

At approximately time 20, a negative going noise pulse on the power supply lines occurs. During this power spike the Vin is much closer to VCC than to VSS resulting in incorrect discrimination of the logic level of Vin. Vout responds by spiking upwards to a logic high until the power supply noise subsides. After the power supply noise stabilizes, Vout returns to the correct value.

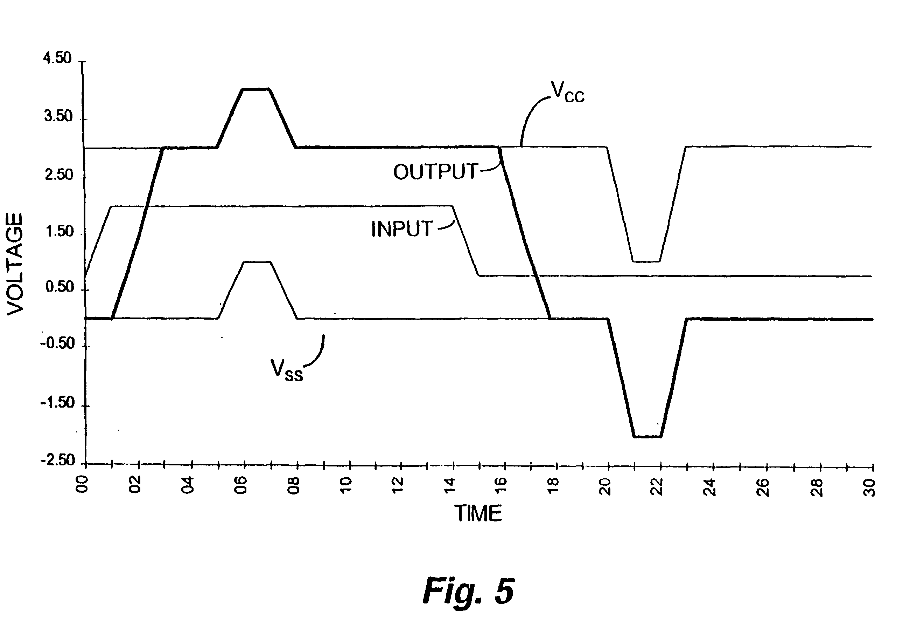

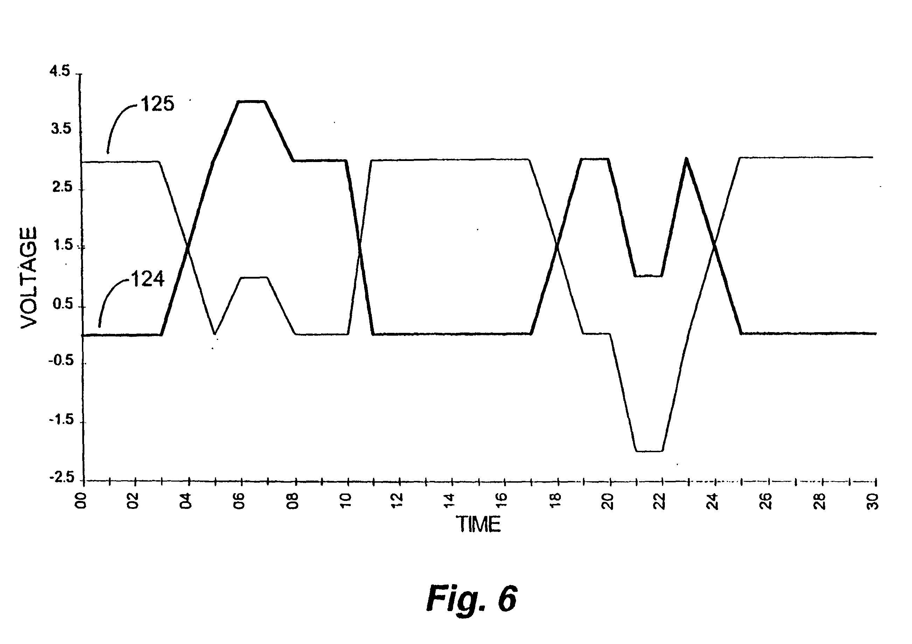

FIG. 5 illustrates a corrected, noise-immune waveform generated by circuit 100 in accordance with the present invention. By comparison of FIG. 4 and FIG. 5, it is readily apparent that the power supply noise occurring at times 05 and 20 does not affect the output voltage of Vout. As shown in FIG. 6 the signals generated by circuit 100 on nodes 124 and 125 are responsible for the superior performance and noise immunity shown in FIG. 5. At time 03 simultaneously with the output changing, the control signal on line 124 drops to a logic low while the control signal on line 125 rises to a logic high. This results in deactivating switches 102 and 103 and disabling input buffer 101. Input buffer 101 remains disabled in the example shown in FIG. 6 until approximately time 11. After time 11 sufficient time has lapsed since at the power supply voltages are stable.

Similarly, during the negative going voltage supply spikes the control signal on line 125 drops to a logic low while the control signal on line 124 goes to a logic high simultaneously with the output voltage change, thereby disabling input buffer 101. Input buffer 101 remains disabled during the supply voltage spike resulting in correct output voltage from the circuit in accordance with the present invention.

Although the invention has been described and illustrated with a certain degree of particularity, it is understood that the present disclosure has been made only by way of example.

## Claims

1. A receiver for an integrated circuit comprising:
an input buffer (101-103) having an input coupled to receive an external input signal and an output coupled to generate a buffered input signal in response to the external input signal, wherein the input buffer (101-103) is selectively enabled by a control signal (124),
a latch (104) coupled to receive the buffered input signal and to generate a latched output signal from the buffered input signal,
a delay circuit (107) coupled to receive the latched output signal and an output coupled to generate a delayed signal, and
a comparator (110) having inputs coupled to receive both the latched output signal and the delayed signal, the comparator (110) having an output coupled to the input buffer (101-103) to generate the control signal (124),
**characterized in that** the input buffer (101-103) comprises: a CMOS inverter (101), a first switch (102) coupled between the CMOS inverter (101) and a V_{DD} voltage supply (VCC), the first switch (102) having a control electrode for receiving the control signal (124),and a second switch (103) coupled between the CMOS inverter (101) and a V_{SS} voltage supply, the second switch (103) having a control electrode for receiving the control signal (124).

2. The receiver of claim 1, **characterized in** further comprising an output driver circuit (106) coupled to receive the latched output signal and an output coupled to generate an output to external circuitry.

3. The receiver of claim 1, **characterized in that** the first CMOS inverter (101) has an input coupled to receive the external input signal and an output coupled to generate the buffered input signal,
the first switch (102) comprises a P-channel FET (102) coupled between the CMOS inverter (101) and the V_{DD} voltage supply (VCC), the P-channel FET (102) having a gate electrode for receiving the control signal (124),
the input buffer further comprises a second CMOS inverter (116) having an input coupled to receive the control signal (124) and an output coupled to generate an inverter control signal (125), and
the second switch (103) comprises an N-channel FET (103) coupled between the CMOS inverter (101) and the V_{SS} voltage supply, the N-channel FET (103) having a gate electrode for receiving the inverted control signal (125).

4. The receiver of claim 1, **characterized in that** the delay circuit (107) comprises a plurality of series coupled CMOS inverters.

5. The receiver of claim 1, **characterized in that** the comparator (110) comprises a two input exclusive-or gate (203, 204) having a first input coupled to the delayed signal, a second input coupled to the latched output signal, and an inverting output providing the control signal (124).

6. A method for receiving a signal in an integrated circuit comprising:
amplifying (101) the received signal by an input buffer (101-103),
coupling the amplified signal to a latch (104), and latching (104) the amplified signal,
**characterized in** comprising:
providing the amplifying function by a CMOS inverter (101) of the input buffer (101-103),
coupling a first switch (102) of the input buffer (101-103) between the CMOS inverter (101) and a V_{DD} voltage supply (VCC),
coupling a second switch (103) of the input buffer (101-103) between the CMOS inverter (101) and a V_{SS} voltage supply,
decoupling (102, 103) the amplified signal from the latch (104) in response to a change in state of the latched signal; and
after a preselected duration of time (107), re-coupling (102, 103) the amplified signal to the latch (104).

7. The method of claim 6, **characterized in that** the step of de-coupling comprises disabling the amplifier (101) providing the amplifying function.

8. The method of claim 6, **characterized in** further comprising the steps of:
generating (107) a delayed amplified signal that is delayed by the preselected duration of time,
comparing (110) the delayed amplified signal to the amplified signal,
in response to the comparing step, performing the de-coupling step (102; 103) when the delayed amplified signal differs from the amplified signal, and
in response to the comparing step (110), performing the re-coupling step when the delayed amplified signal is substantially the same as the amplified signal.

## Patentansprüche

1. Verstärker für einen integrierten Schaltkreis, umfassend:
einen Eingangspuffer (101-103), der einen Eingang aufweist, der gekoppelt ist, um ein externes Eingangssignal zu empfangen, und einen Ausgang, der gekoppelt ist, um dem externen Eingangssignal entsprechend ein gepuffertes Eingangssignals zu erzeugen, wobei der Eingangspuffer (101-103) durch ein Steuersignal (124) auf selektive Weise aktiviert wird,
ein Latch (104), das gekoppelt ist, um das gepufferte Eingangssignal zu empfangen und aus dem gepufferten Eingangssignal ein gelatchtes Ausgangssignal zu erzeugen,
eine Verzögerungsschaltung (107), die gekoppelt ist, um das gelatchte Ausgangssignal zu empfangen, und einen Ausgang, der gekoppelt ist, um ein verzögertes Signal zu erzeugen, und
einen Komparator (110), der Eingänge aufweist, die gekoppelt sind, um sowohl das gelatchte Ausgangssignal als auch das verzögerte Signal zu empfangen, wobei der Komparator (110) einen Ausgang aufweist, der mit dem Eingangspuffer (101-103) gekoppelt ist, um das Steuersignal (124) zu erzeugen,
**dadurch gekennzeichnet, dass** der Eingangspuffer (101-103) umfasst: einen CMOS-Inverter (101), einen ersten Schalter (102), der zwischen dem CMOS-Inverter (101) und einer V_{DD}-Spannungsversorgung (VCC) gekoppelt ist, wobei der erste Schalter (102) eine Steuerelektrode aufweist, um das Steuersignal (124) zu empfangen, und einen zweiten Schalter (103), der zwischen dem CMOS-Inverter (101) und einer V_{SS}-Spannungsversorgung gekoppelt ist, wobei der zweite Schalter (103) eine Steuerelektrode aufweist, um das Steuersignal (124) zu empfangen.

2. Empfänger nach Anspruch 1, **dadurch gekennzeichnet, dass** er außerdem eine Ausgangstreiberschaltung (106) umfasst, die gekoppelt ist, um das gelatchte Ausgangssignal zu empfangen, und einen Ausgang, der gekoppelt ist, um eine Ausgabe an eine externe Schaltung zu erzeugen.

3. Empfänger nach Anspruch 1, **dadurch gekennzeichnet, dass** der erste CMOS-Inverter (101) einen Eingang aufweist, der gekoppelt ist, um das externe Eingangssignal zu empfangen, und einen Ausgang, der gekoppelt ist, um das gepufferte Eingangssignal zu erzeugen,
der erste Schalter (102) einen P-Kanal-FET (102) umfasst, der zwischen dem CMOS-Inverter (101) und der V_{DD}-Spannungsversorgung (VCC) gekoppelt ist, wobei der P-Kanal-FET (102) eine Gateelektrode zum Empfangen des Steuersignals (124) aufweist,
der Eingangspuffer außerdem einen zweiten CMOS-Inverter (116) umfasst, der einen Eingang aufweist, der gekoppelt ist, um das Steuersignal (124) zu empfangen, und einen Ausgang, der gekoppelt ist, um ein Inverter-Steuersignal (125) zu erzeugen, und
der zweite Schalter (103) einen N-Kanal-FET (103) umfasst, der zwischen dem CMOS-Inverter (101) und der V_{SS}-Spannungsversorgung gekoppelt ist, wobei der N-Kanal-FET (103) eine Gateelektrode zum Empfangen des invertierten Steuersignals (125) aufweist.

4. Empfänger nach Anspruch 1, **dadurch gekennzeichnet, dass** die Verzögerungsschaltung (107) eine Vielzahl von in Reihe gekoppelten CMOS-Invertern umfasst.

5. Empfänger nach Anspruch 1, **dadurch gekennzeichnet, dass** der Komparator (110) ein exklusives ODER-Gate (203, 204) mit zwei Eingängen umfasst, mit einem ersten Eingang, der mit dem verzögerten Signal gekoppelt ist, einen zweiten Eingang, der mit dem gelatchten Ausgangssignal gekoppelt ist, und einem Umkehrausgang, der das Steuersignal (124) ausgibt.

6. Verfahren zum Empfangen eines Signals in einem integrierten Schaltkreis, umfassend:
das Verstärken (101) des empfangenen Signals durch einen Eingangspuffer (101-103),
das Koppeln des verstärkten Signals mit einem Latch (104), und das Latchen (104) des verstärkten Signals,
**dadurch gekennzeichnet, dass** es umfasst:
das Bereitstellen der Verstärkerfunktion durch einen CMOS-Inverter (101) des Eingangspuffers (101-103),
das Koppeln eines ersten Schalters (102) des Eingangspuffers (101-103) zwischen dem CMOS-Inverter (101) und einer V_{DD}-Spannungsversorgung (VCC),
das Koppeln eines zweiten Schalters (103) des Eingangspuffers (101-103) zwischen dem CMOS-Inverter (101) und einer V_{SS}-Spannungsversorgung,
das Entkoppeln (102, 103) des verstärkten Signals von dem Latch (104) einer Änderung im Zustand des gelatchten Signals entsprechend, und
nach einer vorgewählten Zeitdauer (107), das Wiederkoppeln (102, 103) des verstärkten Signals mit dem Latch (104).

7. Verfahren nach Anspruch 6, **dadurch gekennzeichnet, dass** der Schritt des Entkoppelns das Deaktivieren des Verstärkers (101) umfasst, der die Verstärkerfunktion bereitstellt.

8. Verfahren nach Anspruch 6, **dadurch gekennzeichnet, dass** es außerdem die Schritte umfasst des:
Erzeugens (107) eines verzögerten verstärkten Signals, das um die vorgewählte Zeitdauer verzögert ist,
Vergleichens (110) des verzögerten verstärkten Signals mit dem verstärkten Signal,
dem Vergleichsschritt entsprechend, Durchführens des Entkopplungsschritts (102; 103), wenn das verzögerte verstärkte Signal vom verstärkten Signal abweicht, und
dem Vergleichsschritt (110) entsprechend, Durchführens des Wiederkopplungsschritts wenn das verzögerte verstärkte Signal im Wesentlichen dem verstärkten Signal gleicht.

## Revendications

1. Récepteur pour un circuit intégré comprenant :
une mémoire tampon d'entrée (101-103) ayant une entrée couplée afin de recevoir un signal d'entrée externe et une sortie couplée afin d'engendrer un signal d'entrée mis en mémoire tampon en réponse au signal d'entrée externe, dans lequel la mémoire tampon d'entrée (101-103) est activée de manière sélective à l'aide d'un signal de commande (124),
un circuit de verrouillage (104) couplé en vue de recevoir le signal d'entrée mis en mémoire tampon et d'engendrer un signal de sortie verrouillé, à partir du signal d'entrée mis en mémoire tampon,
un circuit à retard (107) couplé en vue de recevoir le signal de sortie verrouillé, et une sortie couplée en vue d'engendrer un signal retardé, et
un comparateur (110) ayant des entrées couplées en vue de recevoir à la fois le signal de sortie verrouillé et le signal retardé, le comparateur (110) ayant une sortie couplée à la mémoire tampon d'entrée (101-103) afin d'engendrer le signal de commande (124),
**caractérisé en ce que** la mémoire tampon d'entrée (101-103) comprend : un inverseur CMOS (101), un premier interrupteur (102) couplé entre l'inverseur CMOS (101) et une alimentation de tension V_{DD} (VCC), le premier interrupteur (102) ayant une électrode de commande pour recevoir le signal de commande (124), et un deuxième interrupteur (103) couplé entre l'inverseur CMOS (101) et une alimentation de tension V_{SS}, le deuxième interrupteur (103) ayant une électrode de commande pour recevoir le signal de commande (124).

2. Récepteur selon la revendication 1, **caractérisé en ce qu'**il comprend en outre un circuit d'attaque de sortie (106) couplé en vue de recevoir le signal de sortie verrouillé, et une sortie couplée afin d'engendrer une sortie appliquée à des circuits externes.

3. Récepteur selon la revendication 1, **caractérisé en ce que** le premier inverseur CMOS (101) possède une entrée couplée en vue de recevoir le signal d'entrée externe et une sortie couplée afin d'engendrer le signal d'entrée mis en mémoire tampon,
le premier interrupteur (102) comprend un transistor à effet de champ (TEC) à canal p (102) couplé entre l'inverseur CMOS (101) et l'alimentation de tension V_{DD} (VCC), le TEC à canal p (102) ayant une électrode de grille pour recevoir le signal de commande (124),
la mémoire tampon d'entrée comprend en outre un deuxième inverseur CMOS (116) ayant une entrée couplée en vue de recevoir le signal de commande (124) et une sortie couplée en vue d'engendrer un signal de commande d'inverseur (125), et
le deuxième interrupteur (103) comprend un TEC à canal n (103) couplé entre l'inverseur CMOS (101) et l'alimentation de tension V_{SS}, le TEC à canal n (103) ayant une électrode de grille pour recevoir le signal de commande inversé (125).

4. Récepteur selon la revendication 1, **caractérisé en ce que** le circuit à retard (107) comprend une pluralité d'inverseurs CMOS couplés en série.

5. Récepteur selon la revendication 1, **caractérisé en ce que** le comparateur (110) comprend une porte OU exclusif à deux entrées (203, 204) ayant une première entrée couplée au signal retardé, une deuxième entrée couplée au signal de sortie verrouillé, et une sortie inverseuse fournissant le signal de commande (124).

6. Procédé pour recevoir un signal dans un circuit intégré comprenant :
l'amplification (101) du signal reçu à l'aide d'une mémoire tampon d'entrée (101-103),
le couplage du signal amplifié à un circuit à verrouillage (104), et le verrouillage (104) du signal amplifié,
**caractérisé en ce qu'**il comprend :
la fourniture de la fonction d'amplification à l'aide d'un inverseur CMOS (101) de la mémoire tampon d'entrée (101-103),
le couplage d'un premier interrupteur (102) de la mémoire tampon d'entrée (101-103) entre l'inverseur CMOS (101) et une alimentation de tension VDD (VCC),
le couplage d'un deuxième interrupteur (103) de la mémoire tampon d'entrée (101-103) entre l'inverseur CMOS (101) et une alimentation de tension V_{SS},
le découplage (102, 103) du signal amplifié du circuit à verrouillage (104) en réponse à une modification de l'état du signal verrouillé, et
après une durée présélectionnée (107), le recouplage (102, 103) du signal amplifié au circuit à verrouillage (104).

7. Procédé selon la revendication 6, **caractérisé en ce que** l'étape de découplage comprend la désactivation de l'amplificateur (101) fournissant la fonction d'amplification.

8. Procédé selon la revendication 6, **caractérisé en outre en ce qu'**il comprend les étapes consistant à :
engendrer (107) un signal amplifié retardé qui est retardé de la durée présélectionnée,
comparer (110) le signal amplifié retardé au signal amplifié,
en réponse à l'étape de comparaison, réaliser l'étape de découplage (102; 103) lorsque le signal amplifié retardé diffère du signal amplifié, et
en réponse à l'étape de comparaison (110), réaliser l'étape de recouplage lorsque le signal amplifié retardé est sensiblement le même que le signal amplifié.
